# EUROPEAN PATENT APPLICATION

(11) **EP 2 147 893 A2**
(43) Date of publication of application: **27.01.2010**
(21) Application number: 09166062.1
(22) Date of filing: 21.07.2009
(51) Int. Cl.: B81B 7/00, B81C 3/00

(54) **MEMS die to bump alignment**

(30) Priority: 25.07.2008 US 180336
(71) Applicant: Honeywell International Inc., Morristown, NJ 07962 (US)
(72) Inventor: Seppala, Bryan, Morristown, NJ 07962-2245 (US); Dcamp, Jon, Morristown, NJ 07962-2245 (US); Curtis, Harlan, Morristown, NJ 07962-2245 (US); Glenn, Max, Morristown, NJ 07962-2245 (US); Dunaway, Lori, Morristown, NJ 07962-2245 (US)
(74) Representative: Buckley, Guy Julian

(57) **Abstract**

A Leadless Chip Carrier (LCC) device and method of attaching a Microelectromechanical (MEMS) device into an LCC package. An alignment plate is die bonded into the bottom of an LCC. The alignment plate includes fiducials fabricated into top and bottom metal layers, thus producing a tolerance that will be an order of magnitude better than the tolerance of fiducials included in the LCC. A bump pattern and MEMS die are attached based on the alignment plate and fiducials giving a much improved die to bump alignment.

## Description

### BACKGROUND OF THE INVENTION

Current Microelectromechanical (MEMS) Leadless Chip Carriers (LCCs) have a +/- 5 mil (125 micron) tolerance on dimensions and fiducials. The bump pattern alignment to the MEMS die can be no better than the tolerance of the LCC package. The MEMS die to bump alignment is important to the performance of the packaged MEMS sensor.

### SUMMARY OF THE INVENTION

The present invention provides an alignment plate attached to the die bond pad attached to an LCC package. The alignment plate includes fiducials fabricated into top and bottom metal layers, thus producing a tolerance that will be an order of magnitude better than the tolerance of fiducials included in the LCC. A bump pattern and/or MEMS die are attached to the alignment plate based on the alignment plate fiducials giving a much improved die to bump alignment.

### BRIEF DESCRIPTION OF THE DRAWINGS

Preferred and alternative embodiments of the present invention are described in detail below with reference to the following drawings:

FIGURE 1 illustrates a cross-sectional view of an LCC with a secured MEMS device formed in accordance with an embodiment of the present invention;

FIGURES 2-1 through 2-4 illustrate steps in an example process for attaching a MEMS device within the LCC package in accordance with an embodiment of the present invention;

FIGURE 3 illustrates a top-down view of an alignment plate mounted within an LCC package; and

FIGURE 4 illustrates a side cross-sectional view of an alignment plate formed in accordance with an embodiment of the present invention.

### DETAILED DESCRIPTION OF THE INVENTION

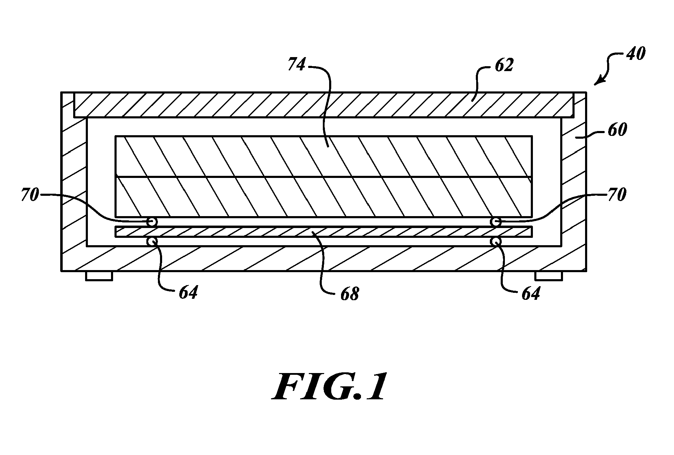

As shown in FIGURE 1, an example LCC package 40 includes an alignment plate 68 and MEMS die 74 secured within a cavity formed by a base section 60 (die bond pad) and a cover 62. The alignment plate 68 is die bonded into the bottom of the base section 60. The alignment plate 68 includes one or more fiducials that are applied to a top and bottom surfaces of the alignment plate 68 using wafer fabrication processing. The tolerance or accuracy of the alignment plate fiducials are an order of magnitude better than that of fiducials that may be formed onto the base of the base section 60. A bump pattern 70 is formed onto the alignment plate 68 based on the alignment plate fiducials. Then, the MEMS die 74 is attached to the bump pattern 70, thus improving MEMS die to bump alignment.

In one embodiment, the alignment plate 68 is formed of glass. The top and bottom sides of the alignment plate 68 include a deposited metallization layer (e.g. Ti/Pt/Au). The thickness of the glass plate is between 0.01" (250 µm) and 0.03" (760 µm). Other thicknesses can be used. On both sides of the glass plate (wafer) saw streets and fiducials are patterned into the metallization layer using typical water fab photolithography and etching techniques.

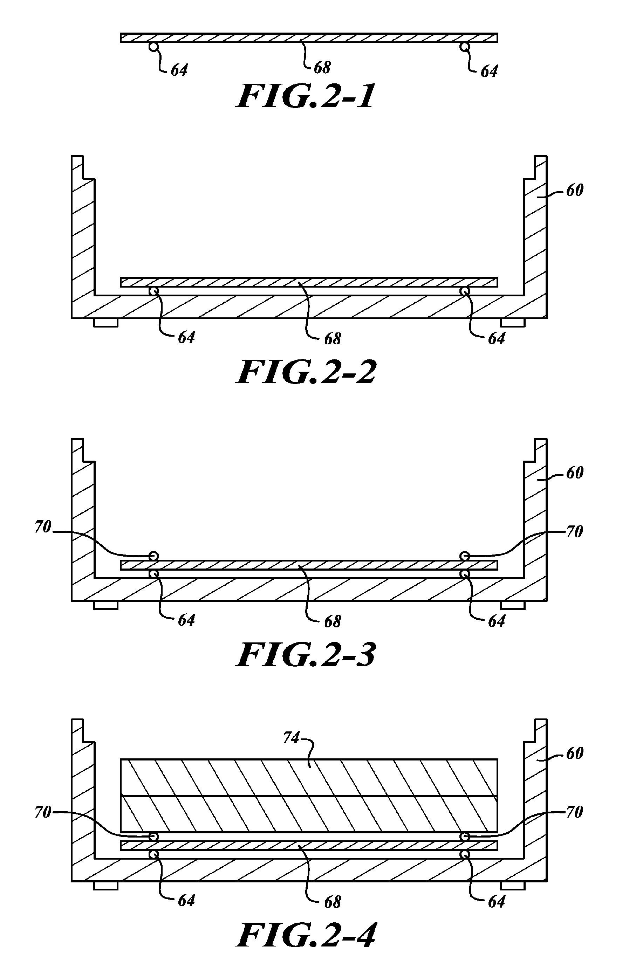

As shown in FIGURE 2-1, the alignment plate 68 will be bumped with a first bump pattern 64 in wafer form to ensure alignment of a second bump pattern 70. After the alignment plate 68 in wafer form is sawed with prepatterned bumps (the first bump pattern 64), the alignment plate 68 is die bonded into the LCC (the base section 60) using flip chip thermal compression die bonding (FIGURE 2-2). As shown in FIGURE 2-3, the second bump pattern 70 is applied by a wirebonder device onto the alignment plate 68 based on the previously fabricated fiducials on the alignment plate 68. Then, as shown in FIGURE 2-4, the MEMS die 74 is attached on the alignment plate 68 (the second bump pattern 70) based on the same fiducials used to apply the second bump pattern 70.

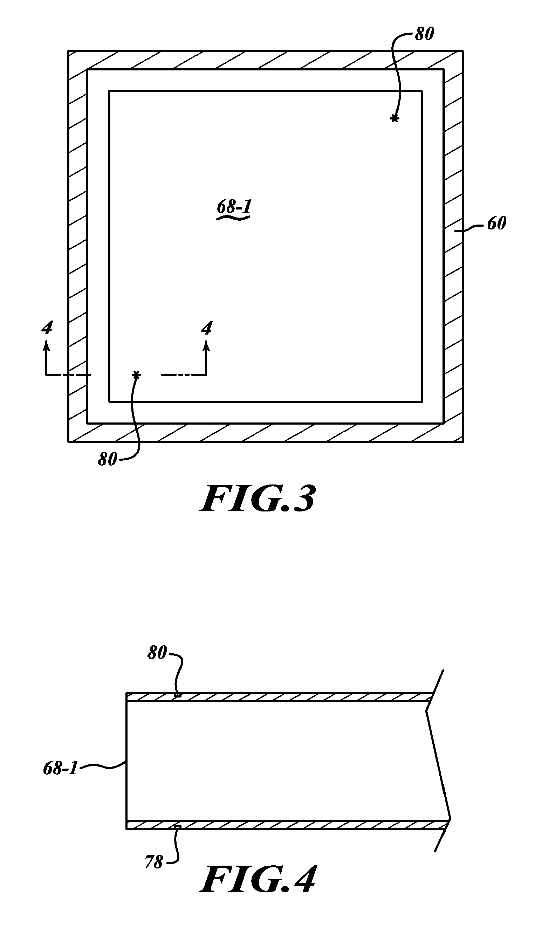

FIGURE 3 illustrates a top view of an alignment plate 68-1 mounted inside the base section 60 of the LCC. In this embodiment, the alignment plate 68-1 includes 2 sets of fiducials 78 and 80 (i.e., visual cues). The fiducials 78 of the first set are located at opposing corners of the bottom surface of the alignment plate 68-1. The fiducials 80 of the second set are located at opposing corners of the top surface of the alignment plate 68-1. FIGURE 4 illustrates a partial cross-sectional view of the alignment plate 68-1. The fiducials 78 and 80 are etched into a respective metal layer but not into the glass of the alignment plate 68-1.

A bump application device (not shown) (e.g., an automatic (robotic) wirebonder device) visually acquires the fiducials 80 using an imaging device. The bump application device determines where to apply the bumps (the bump pattern 70) to the alignment plate 68-1 based on the acquired fiducials 80. The MEMS die 74 is then attached (robotically) to the second bump pattern 70 using automatic visual acquisition of the fiducials 80.

While the preferred embodiment of the invention has been illustrated and described, as noted above, many changes can be made without departing from the spirit and scope of the invention. Accordingly, the scope of the invention is not limited by the disclosure of the preferred embodiment. Instead, the invention should be determined entirely by reference to the claims that follow.

## Claims

1. A Leadless Chip Carrier (LCC) Microelectromechanical (MEMS) device comprising:
an LCC housing (40);
an alignment plate (68) attached to an interior base (60) of the LCC housing (40);
a plurality of bumps (70) attached to a first side of the alignment plate, the first side of the alignment plate being opposite a second side of the alignment plate (68) that is proximate to the interior base (60) of the LCC housing (40); and
a MEMS die (74) attached to the plurality of bumps (70) that are attached to the first side of the alignment plate (68).

2. The device of Claim 1, further comprising:
a plurality of bumps (64) located between the interior base (60) of the LCC housing (40) and the alignment plate (68), the location of the plurality of bumps (64) being based on one or more fiducials included in the interior base (60) of the LCC housing (40).

3. The device of Claim 1, wherein the alignment plate (68) comprises at least one of glass, silicon, or other ceramic material.

4. The device of Claim 3, wherein the alignment plate (68) comprises a metal layer on the first and second sides.

5. The device of Claim 4, wherein the alignment plate (68) comprises one or more fiducials (78, 80) fabricated into the metal layer on the first and second sides.

6. The device of Claim 5, wherein the locations of the plurality of bumps (64, 70) attached to the first and second sides of the alignment plate (68) are based on the one or more fiducials (78, 80) fabricated into the metal layer on the first side.

7. A method of fabricating a Leadless Chip Carrier (LCC) Microelectromechanical (MEMS) device, the method comprising:
attaching an alignment plate (68) to an interior base (60) of an LCC housing (40);
attaching a plurality of bumps (70) to a first side of the alignment plate (68), the first side of the alignment plate (68) being opposite a second side of the alignment plate (68) that is proximate to the interior base (60) of the LCC housing (40); and
attaching a MEMS die (74) to the plurality of bumps (70) that are attached to the first side of the alignment plate (68).

8. The method of Claim 7, wherein attaching the alignment plate (68) comprises: attaching a plurality of bumps (64) to the second side of the alignment plate (68) based on one or more fiducials (78) included on the second side of the alignment plate (68).

9. The method of Claim 8, wherein attaching the plurality of bumps (64) to the second side is performed when the alignment plate (68) is in wafer form.

10. The method of Claim 7, wherein the alignment plate (68) comprises:
at least one of glass, silicon, or other ceramic material; and
a metal layer on the first and second sides;
the method further comprising fabricating one or more fiducials (80) into the metal layer on the first side, wherein attaching the plurality of bumps (70) to the first side of the alignment plate (68) further comprises attaching the plurality of bumps (80) based on the fabricated one or more fiducials (80).
